# EUROPEAN PATENT SPECIFICATION

(11) **EP 2 661 034 B1**
(45) Date of publication and mention of the grant of the patent: **11.03.2020**
(21) Application number: 12166877.6
(22) Date of filing: 04.05.2012
(51) Int. Cl.: H04L 25/493, H04L 25/02

(54) **Electric circuit arrangement for galvanic isolated communication**
Elektrische Schaltanordnung für galvanisch isolierte Kommunikationen
Agencement de circuit électrique pour communication isolée galvanique

(43) Date of publication of application: 06.11.2013
(73) Proprietor: ams AG, 8141 Premstätten (AT)
(72) Inventor: Vinau, Jose, 46007 Valencia (ES); Poirier, Sébastien, 46023 Valencia (ES); Enichlmair, Hubert, 8044 Weinitzen (AT); Ele, Vijay, 500072 Kukutpally, Hyderabad (IN); Ranganathan, Rohit, 500032 Hyderabad (IN); Brandl, Manfred, 8112 Gratwein (AT)
(74) Representative: Epping - Hermann - Fischer

(56) References cited:
- US-A- 5 774 791
- US-A- 5 952 849
- US-A1- 2005 073 293
- US-A1- 2007 216 377
- US-A1- 2008 267 301
- US-A1- 2010 231 174
- US-A1- 2011 235 737

## Description

### Technical Field

The invention is directed to an electric circuit arrangement for galvanic isolated communication which may be used for charge balancing systems.

### Background

A galvanic isolated communication path between a transmitter device and a receiver device may be necessary, if the transmitter device and the receiver device are operated in different voltage domains. In charge balancing systems in which battery packs are coupled in series between a supply and a reference potential, each device coupled to one of the battery packs is operated in a separate voltage domain.

A battery pack typically comprises stacked battery cells to sum up the individual cell voltages of the battery cells. A plurality of such battery packs connected in series between a supply and reference potential forms a stacked battery system. Stacked battery systems are essential, for example, for electric and hybrid automobiles. The stacked battery systems usually deliver voltages from 12 V for mobile computers, power tools and toys, 24 V for electric bikes and 200 V for hybrid electric vehicles, and up to 600 V for electric vehicles with perspectives of up to 1000 V.

The battery packs of a battery stack are very expensive and need careful treatment when charged or discharged to ensure long battery life, health and safety. This requires accurate charge balancing to avoid overcharge or over-depletion of the individual cells within the pack. Each battery pack in the pack needs intelligence to perform charge balancing to enhance the battery life time of the pack, and hence of the stack. For charge balancing systems, each battery pack needs control to ensure that a charging circuit, such as a DC-DC fly-back converter, can charge each cell to a defined voltage so that all the cells are balanced.

Isolated communication requirements are arising in the EV/HEV (Electric Vehicle/Hybrid Electric Vehicle) technologies where there are large battery packs which need to communicate with other devices to perform various functions like SOC/SOH (State of Charge/State of Health) measurement, charge balancing, battery charging etc.. In charge balancing systems the charge condition of each battery cell in a battery pack has to be detected to decide, if it is necessary to reload a battery cell which has a charge condition lower than a desired charge for all of the battery cells of the battery pack. A communication between a transmitter device comprising a detection circuit to detect the charge condition of each battery cell and a receiver device and a charging circuit to recharge individual battery cells is required.

US 2008/0267301 A1 is directed to an electric circuit arrangement of a bidirectional integrated circuit isolator for providing bidirectional data transfer of digital signals across a voltage isolation barrier. The electric circuit arrangement comprises a transmitter circuit inductively coupled by a transformer to a receiver circuit to generate an output signal in dependence on an input signal of the transmitter circuit.

US 2011/0235737 A1 is directed to an isolated communication system comprising a transmission unit to generate a transmission pulse signal which is received by a receiving unit to decode the received pulse signal via an isolated communication unit.

US 2010/0231174 A1 relates to a circuit for charging a battery pack comprising a charge controller to generate a pulse width modulation signal such that a duty cycle of the pulse width modulation signal is adjusted to control a charging power provided by a fly-back DC to DC converter. The charge controller is coupled via a pulse transformer to a control switch to control the fly-back DC to DC converter.

US 2007/0216377 A1 is directed to a power electronics equipment comprising a plurality of insulating transformers, wherein a respective transformer may be formed by a pair of in-series connected coils at a primary side and in-series connected coils at a secondary side of the transformer.

It is desirable to provide an electric circuit arrangement for galvanic isolated communication which enables communication between a transmitter circuit comprising a detection circuit to detect a charge condition of a battery cell of a battery pack and a receiver circuit coupled to a charge circuit to recharge a battery cell of the battery pack.

### Summary

An electric circuit arrangement for galvanic isolated communication is specified in claim 1. Preferred embodiments are defined in the dependent claims. Aspects or embodiments that do not fall under the scope of the claims are useful to understand the invention.

According to an embodiment of an electric circuit arrangement for galvanic isolated communication, the circuit arrangement comprises a transmitter circuit having an input side for applying a digital signal and an output side for generating an output signal in dependence on the digital signal. The electric circuit further comprises a receiver circuit having an input side for receiving an input signal and having an output side for generating a reconstructed digital signal in dependence on the input signal. The electric circuit arrangement may also comprise a transformer for inductive coupling the output side of the transmitter circuit to the input side of the receiver circuit. The electric circuit arrangement comprises a battery pack including a plurality of battery cells, a charging circuit to recharge the battery cells, wherein the charging circuit is coupled to the receiver circuit, and a detection circuit to detect a charge condition of each of the battery cells. The detection circuit is configured to generate the digital signal, when the detection circuit detects that the charge condition of one of the battery cells is below a threshold value. The transmitter circuit is configured to generate the output signal in dependence on the digital signal.

The electric circuit arrangement enables to transmit a digital signal from a transmitter circuit to a receiver circuit by a galvanic isolated communication path. The digital signal may be formed as a signal having pulses with a rising and falling edge. In particular, the digital signal may be a pulse width modulated signal. The electric circuit arrangement provides an architecture for communication with inductive coupling of the transmitter circuit and the receiver circuit using an on-chip transformer which rely on a current-based driver driving a primary coil of the transformer. A secondary side of the transformer may comprise secondary coils or Hall sensor elements which are coupled to the receiver circuit. The receiver circuit understands the levels in the digital data based on signal levels or signal pulses observed at the secondary side of the transformer. The entire transmission and reception of information signals may be coded as current levels/pulses.

The electric circuit arrangement is adapted to transmit digital signals by controlling the current flowing in the inductive coils of the transformer. The approach to control the current in the coils of the transformer provides good immunity against current surges in the primary coil of the transformer. The electric circuit arrangement provides a current-based coding for transmission and reception of signals and a magnetic isolated fly-back control driver for fly-back transformers.

According to a possible embodiment of the electric circuit arrangement, an output current generated by a transmitter device is fed to the primary coil of the transformer in a predefined pattern or a predefined magnitude and will be received as a current pattern or magnitude which corresponds to a rising and falling edge of a digital signal. A reconstructed digital signal can be generated by the receiver circuit in dependence on the received current pattern or current magnitude.

According to another embodiment of an electric circuit arrangement, the communication strategy using on-chip transformers relies on a differential measurement for data communication. The transformer has a differential coil structure which has the possibility for each coil to have a different direction for the current flow. The receiver measures the difference in the currents in both the coils to detect the digital state transmitted. This enables to measure the difference in the currents in the coils to measure the magnitude of the current, for example I and -I, which indicates state "0" or "1" of the digital data. This differential structure has an inherent immunity to static and random magnetic fields and hence a greater immunity to stray magnetic fields. This structure also simplifies the transmitter and makes it possible to also interface with a generic micro-controller.

### Brief Description of the Drawings

Figure 1 shows an electric circuit arrangement for a galvanic isolated communication in a charge balancing system.
Figure 2 shows an embodiment of an electric circuit arrangement comprising a transmitter circuit to transmit a digital signal via inductive coupling to a receiver circuit.
Figure 3 shows a block diagram of a communication channel to transmit a data signal from a transmitter to a receiver by an inductive coupling.
Figure 4A shows an embodiment of a transmitter circuit of an electric circuit arrangement for a galvanic isolated communication.
Figure 4B shows a course of a digital signal and an output signal of a transmitter circuit.
Figure 5A shows an embodiment of a receiver circuit of an electric circuit arrangement for a galvanic isolated communication.
Figure 5B shows a course of an output signal of the transmitter circuit and an input signal of the receiver circuit.
Figure 6A shows a second embodiment of a transmitter circuit of an electric circuit arrangement for a galvanic isolated communication.
Figure 6B shows a course of a digital signal and an output signal of the transmitter circuit.
Figure 7A shows a second embodiment of a receiver circuit of an electric circuit arrangement for a galvanic isolated communication.
Figure 7B shows a course of an output signal of the transmitter circuit and an input signal of the receiver circuit.
Figure 8 shows a block diagram of a communication channel to transmit a data signal from a transmitter circuit to a receiver circuit by an inductive coupling.
Figure 9 shows an embodiment of a receiver circuit of an electric circuit arrangement for a galvanic isolated communication.
Figure 10 shows an embodiment of comparator circuits of the receiver circuit.
Figure 11 shows an embodiment of a control circuit to control the comparator circuits.
Figure 12 shows an embodiment of a control circuit to generate a reset signal to turn off the receiver circuit.
Figure 13 shows a signal diagram for illustrating the function of the receiver circuit.
Figure 14 shows an embodiment of a glitch correction algorithm of the receiver circuit.
Figure 15 shows a signal diagram illustrating the glitch correction scheme of the receiver circuit.
Figure 16 shows a cross-section of a galvanic isolator integrated in a one-chip solution together with standard CMOS devices.
Figure 17 shows transceiver and receiver coils of a transformer being positioned on top of each other.
Figure 18 shows a transformer with receiver coils and Hall sensor elements being positioned on top of each other.

### Detailed Description

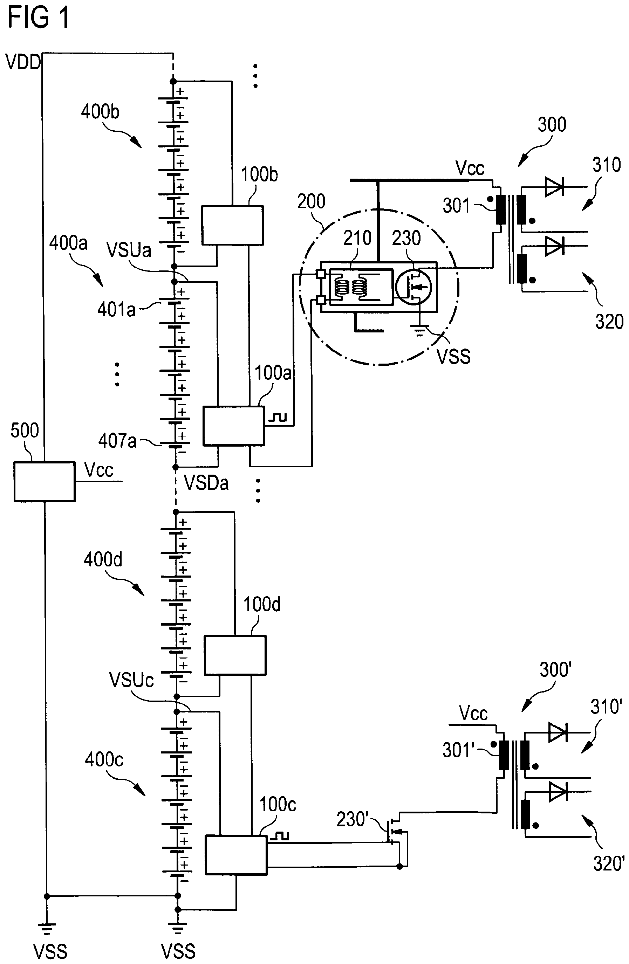

Figure 1 shows an embodiment of transmitter devices 100a, 100b being inductively coupled to a receiver device 200. The transmitter device 100a is galvanically isolated and inductively to the receiver device 200 by means of transformer 210. The transmitter device 100b is galvanically isolated from the receiver device 200 and inductively coupled to the receiver device 200 via the transmitter device 100a. The transmitter devices are galvanically isolated from the receiver circuit 200 or the charging circuit 300, because the transmitter devices 100a, 100b are operated in another voltage domain than the receiver device 200 or the charging circuit 300. Each of the transmitter devices contains a detector circuit provided to monitor a charge condition of battery cells of a battery pack. The transmitter devices 100a, 100b, 100c and 100d are connected to the battery packs 400a, 400b, 400c and 400d. Each of the battery packs comprises battery cells 401, ..., 407.

In the example shown in Figure 1 two transmitter devices 100a, 100b respectively monitor the condition of seven battery cells of battery packs 400a, 400b. The transmitter device 100a is coupled to a transformer 210 of the receiver device 200. The transmitter device 100b is coupled to the transformer 210 of the receiver device 200 by means of the transmitter device 100a. In the embodiment shown in Figure 1 the split of a transmitter device in devices 100a and 100b is a dedicated solution to reduce the number of transformers in a battery system for cost reasons. However, according to another possible embodiment not shown in Figure 1, one transformer 210 comprising a primary and secondary coil may be provided per transmitter device 100a, 100b.

A plurality of in-series connected battery packs form a battery stack. A DC-DC converter device 500 is connected between a high potential VDD of the battery pack and a reference potential VSS which may be the ground potential. The DC-DC converter device 500 provides a supply potential VCC to supply the charging circuit 300. The charging circuit 300 may be formed as a fly-back converter comprising a primary side 301 with a primary coil 301 and a secondary side with secondary coils 310, 320. The primary coil of charging circuit 300 is controlled or driven by a driver circuit 230 of the receiver circuit 200 coupled between the charging circuit 300 and the reference potential VSS. The charging circuit 300 is configured to charge the battery cells of the battery packs 400a, 400b. To this purpose, the secondary coil 310 of charging circuit 300 may be coupled to the battery pack 400a through switches inside the transmitter device 100a to recharge the battery cells of battery pack 400a and the secondary coil 320 may be coupled to the battery pack 400b through switches inside the transmitter device 100b to recharge the battery cells of battery pack 400b.

The transmitter circuit 100a monitors the charge condition of the battery cells 401, ..., 407 of the battery pack 400a. If it is detected, that one of the battery cells, for example battery cell 401, has a charge condition which is lower than a desired threshold value, for example the average charge of all battery cells of the respective battery pack 400a, the transmitter device 100a generates an output signal which is applied to the primary side of transformer 210. The transmitter device 100a may generate the output signal in dependence on the detected charge condition of the battery cell 401, if the transmitter device has detected that battery cell 401 has a charge condition below the threshold value. The transmitter device 100a may be configured to generate a digital signal with a fixed duty cycle or a duty cycle in dependence on the detected charge condition of battery cell 401. The transmitter device 100a may provide a pulse width modulated signal PWM. The duty cycle of the digital signal determines the energy quantity converted to magnetic domain of the transformer 210 and finally the charge quantity available at the secondary side of the transformer coils 210. The output signal of the transmitter device 100a is inductively coupled by transformer 210 of receiver device 200 to the driver circuit 230. The driver circuit 230 is coupled to the charging circuit 300 to drive the primary coil 301 of the fly-back converter 300. The driver circuit 230 controls the charging circuit 300 which generates a voltage to recharge battery cell 401. The variability of the duty cycle of the pulse width modulated signal enables to avoid too large currents causing high temperature of integrated switches. The pulse width modulated signal may be generated with a fixed duty cycle. Charge packages which are fixed in magnitude and in length sequentially to cells which are below a threshold value in a repeated manner until all cells show the same voltage. The cells may also be charged by charge packages with variable magnitude dependent on the charge condition of the battery cells.

The electric circuit arrangement for charge balancing further comprises a transmitter device 100c to monitor the charge condition of the battery cells of battery pack 400c, and a transmitter device 100d to monitor the charge condition of the battery cells of battery pack 400d. The transmitter devices 100c, 100d are directly connected to a driver circuit 230' without coupling a transformer between the driver circuit and the transmitter device for a galvanic isolation. The driver circuit 230 may be connected to a primary side 301' of a charging circuit 300'.

If the charging circuit 300' is formed as a fly-back converter, the driver circuit 230' may drive the primary coil of the charging circuit 300'. The secondary side of the fly-back converter 300' may comprise a secondary coil 310' coupled to the battery pack 400c to recharge the battery cells of battery pack 400c and a secondary coil 320' coupled to the battery pack 400d to recharge the battery cells of battery pack 400d. In contrast to the galvanic isolated coupling of the transmitter device 100a to the receiver device 200 with its driver circuit 230, the transmitter device 100c is directly coupled to the driver circuit 230' without providing an inductive coupling between the transmitter device 100c and the driver circuit 230'. This is due to the fact that the driver circuit 230'/the charging circuit 300' and the transmitter device 100c are operated in the same voltage domain. The transmitter device 100c is coupled between a supply potential VSUc and a ground potential VSS. Since the driver circuit 230' and the charging circuit 300' are connected to the same ground potential VSS as the transmitter device 100c, it is possible to directly connect the transmitter device 100c with the driver circuit 230' and the charging circuit 300'.

As further illustrated in Figure 1, the receiver device 100a is connected to a supply potential VSUa and a reference potential VSDa which is different from the ground potential VSS to which the driver circuit 230 and the charging circuit 300 are connected. Since the driver circuit 230 and the charging circuit 300 are connected to the reference potential VSS, which may be the ground potential, and which is different from the reference potential VSDa, it is not possible to directly couple the transmitter device 100a to the driver circuit 230. Since the transmitter device 100a and the receiver device 200 are operated in different voltage supply/ground domains, the driver circuit 230 and the transmitter device 100a are galvanically isolated and inductively coupled to each other by the transformer 210.

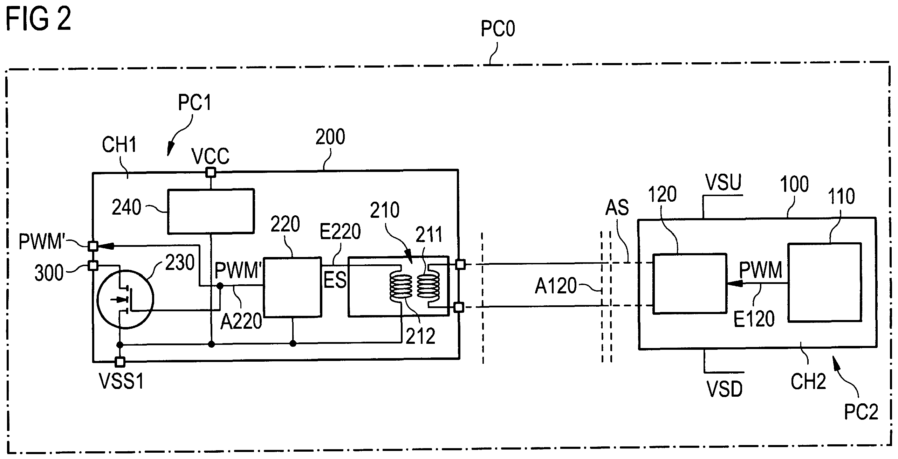

Figure 2 shows the transmitter device 100 and the receiver device 200 in greater detail. The transmitter device 100 comprises a detection circuit 110 to detect a charge condition of each of the battery cells to which the transmitter device is connected. The transmitter device 100 further comprises a transmitter circuit 120 having an input side E120 for applying a digital signal PWM and an output side A120 for generating an output signal AS. The detection circuit 110 may generate a signal, for example a pulse width modulated signal PWM, when the detection circuit 110 detects that the charging state of one of the battery cells 401, ..., 407, to which the transmitter device 110 is coupled, is below a threshold value. The detection circuit 110 may be configured to generate the digital signal PWM with a duty cycle in dependence on the charge condition of each of the battery cells 401, ..., 407 of the battery pack having a charging state below the threshold value. If the threshold value is an average voltage of all of the battery cells of the battery pack, the detection circuit 110 may generate the digital signal PWM, when the detection circuit 110 detects that one of the battery cells has a charging state below the average charging state of all the battery cells of the battery pack. The transmitter circuit 120 generates an output signal AS in dependence on the digital signal PWM which is applied by the detection circuit 110 to its input side E120.

The receiver device 200 comprises a transformer 210, a receiver circuit 220, a driver circuit 230 and a voltage regulator 240. The voltage regulator 240 generates internal voltages being adapted to operate the receiver circuit 220. The internal voltages are generated by the voltage regulator from an external voltage VCC which may be provided by the DC-DC converter 500. The voltage regulator 240 can be omitted, if the external voltage VCC is a stable voltage. The transformer 210 comprises a primary side 211 coupled to an output side A120 of the transmitter circuit 120 and a secondary side 212 coupled to an input side E220 of the receiver circuit 220. The primary side of the transformer may comprise a primary coil 211, and the secondary side may comprise a secondary coil 212. The transformer 210 is configured for inductive coupling of the side A120 of the output transmitter circuit 120 to the input side E220 of the receiver circuit 220. The transformer 210 generates the input signal ES at the secondary side 212 in dependence on the output signal AS applied to its primary side 211.

The receiver circuit 220 receives the input signal ES provided from the secondary side 212 of the transformer, when the output signal AS is applied to the primary side 211 of the transformer. The receiver circuit 220 generates a reconstructed digital signal PWM' in dependence on the input signal ES. The reconstructed digital signal may be formed as a digital signal with rising or falling edges. The reconstructed digital signal may be formed as a pulse width modulated signal. The reconstructed digital signal PWM' is used to control the driver circuit 230 which may comprise a transistor. The reconstructed digital signal PWM' may be applied to a control terminal of the transistor. The driver circuit may be connected to the charging circuit 300. If the charging circuit 300 is realized as a fly-back converter, the driver circuit 230 may be coupled to the primary side of the fly-back converter to drive its primary coil 301.

When the detection circuit 110 detects that the charge condition of one of the battery cells 401, ..., 407 is below the threshold value, the detection circuit may generate the digital signal PWM with a fixed duty-cycle or optionally with a duty cycle in dependence on the charge condition of the battery cell which has the charge condition below the threshold value. The transmitter circuit 120 generates the output signal AS in dependence on the digital signal PWM which is applied to the input side E120 of the transmitter circuit.

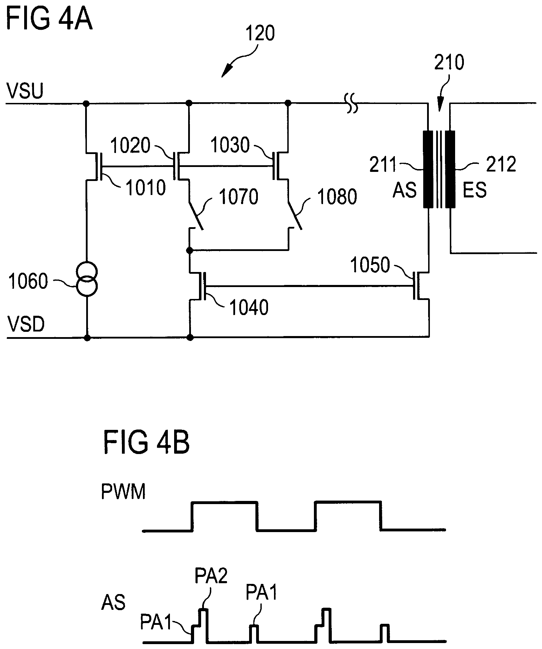

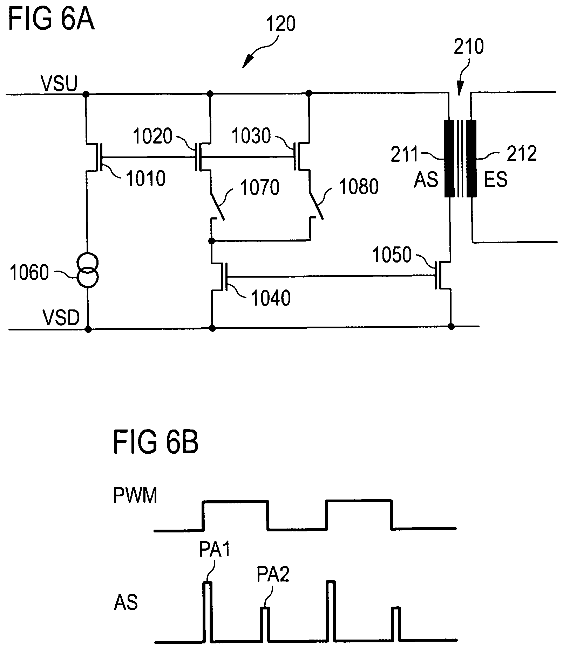

According to a first embodiment which is illustrated in more detail in Figures 4A to 5B the transmitter circuit 120 may generate the output signal AS with a sequence of at least two different amplitudes PA1, PA2, when one of a rising edge and falling edge of the pulses of the digital signal PWM is applied to the input side E120 of the transmitter circuit 120, and the transmitter circuit 120 may be configured to generate the output signal AS with at least one amplitude, when the other one of the rising and falling edge of the pulses of the digital signal PWM is applied to the input side E120 of the transmitter circuit 120. The transformer 210 may be configured to generate the input signal ES with a sequence of at least two signal peaks PE1, PE2 when the sequence of the at least two different amplitudes is applied to the transformer 210, and the receiver circuit 220 may be configured to generate the reconstructed digital signal PWM' with one of the rising and falling edge, when the receiver circuit 220 detects the sequence of the at least two signal peaks PE1, PE2 of the input signal ES. The transformer 210 may be configured to generate the input signal ES with at least one signal peak, when the output signal AS is applied to the transformer with the at least one amplitude. The receiver circuit 220 may be configured to generate the reconstructed digital signal PWM' with the other one of the rising and falling edge, when the receiver circuit 220 detects the at least one signal peak of the input signal ES. According to a second embodiment which is illustrated in more detail in Figures 6A to 7B, the transmitter circuit 120 may be configured to generate the output signal AS with one first amplitude PA1 or one second amplitude PA2 in dependence on the rising or falling edge of the pulses of the digital signal PWM applied to the transmitter circuit 120. The transformer 210 may configured to generate the input signal ES with an amplitude PE1, PE2 in dependence on the amplitude of the output signal AS. The receiver circuit 220 may be configured to detect an amplitude PE1, PE2 of the input signal ES applied to the input side E220 of the receiver circuit 220 and to generate the reconstructed digital signal PWM' with a rising or falling edge in dependence on the detected amplitude of the input signal ES.

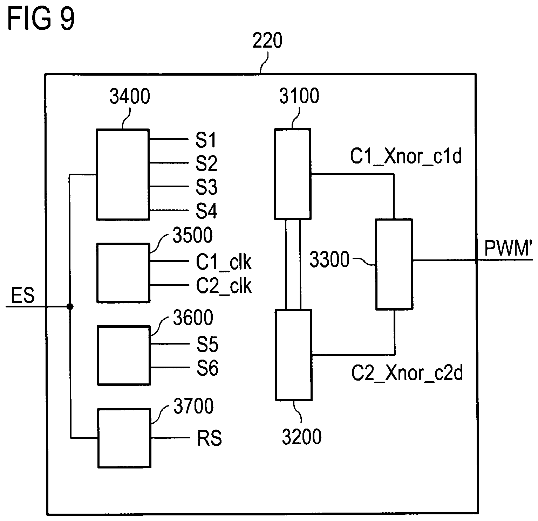

According to a third embodiment which is illustrated in more detail in Figures 9 to 15 the transmitter circuit 120 and the transformer 210 are configured to generate the input signal ES with a signal pulse P1, P2, P3 for each one of a rising and falling edge of the digital signal PWM applied to the transmitter circuit 120. The receiver circuit 220 is configured to detect a first time duration T₁ between a first and a second signal pulse P1, P2, the second signal pulse P2 being applied to the receiver circuit 220 subsequently in relation to the first signal pulse P1, and to detect a second time duration T₁' between the second signal pulse P2 and a third signal pulse P3, the third signal pulse P3 being applied to the receiver circuit 220 subsequently in relation to the second signal pulse P2. The receiver circuit 220 may be configured to compare the first and second time duration T₁, T₁'. The receiver circuit 220 generates the reconstructed digital signal PWM' with a high pulse HP for the first time duration T₁ and with a low pulse LP for the second time duration T₁', when the first time duration T₁ is shorter than the second time duration T₁'. The receiver circuit 220 generates the reconstructed digital signal PWM' with a high pulse HP for the second time duration T₁' and with a low pulse LP for the first time duration T₁, when the second time duration T₁' is shorter than the first time duration T₁.

According to an embodiment the transformer 210 and the receiver circuit 220 are integrated in a chip CH1 and the transmitter circuit 120 is integrated in a separate chip CH2. That means the on-chip coil transformer 210 is activated with the output signal AS of the transmitter driver circuit 120 wherein the transmitter driver circuit 120 is disposed on another die than the on-chip coil transformer 210. The primary coil 211 may be disposed on one of metal layers of the chip CH1 and the secondary coil 212 may be arranged in another metal layer of the chip CH1. The transmitter circuit 120 in the chip CH2 can be coupled to a completely different supply/ground domain than the secondary coil 212 of the transformer 210 and the receiver 220 in chip CH1.

According to an embodiment the transformer 210 and the receiver circuit 220 may be housed in a package PC1, and the transmitter circuit 120 is housed in a package PC2 which is different from the package PC1. According to a further embodiment there is also the possibility to have a dual die solution with a split lead frame where the driver section and the transformer plus the receiver section can be packed in the same package but connected to different supply and ground domains. In Figure 2, the dashed line shows this further embodiment wherein the transmitter device 100 including the transmitter circuit 120, and the receiver device 200 including the transformer 210 and the receiver circuit 220 are encapsulated in the same package PC0.

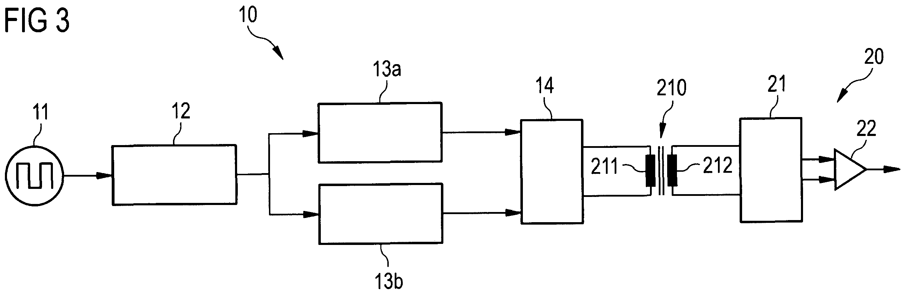

Figure 3 shows a block diagram of a communication channel to transmit a data signal from a transmitter stage 10 to a receiver stage 20 by an inductive coupling. A data signal is generated in a data signal generator 11 and filtered by a noise/glitch filter 12. The input stage 10 of the communication channel further comprises an edge detector 13a and a falling/rising edge detector 13b which are coupled to a current controlled driver 14. The edge detector 13a detects any transition on the data signal. The detector 13b detects, if an edge of the data signal is a rising or a falling edge. The current controlled driver 14 generates the output signal AS which is fed to the primary side 211 of the transformer 210. The output signal AS is inductively coupled to the secondary side 212 of the transformer 210. The secondary side 212 is coupled to a current detector 21 and a comparator 22 which generates the reconstructed data signal by comparing the detected current at the secondary side 212 of the transformer 210 with a reference current.

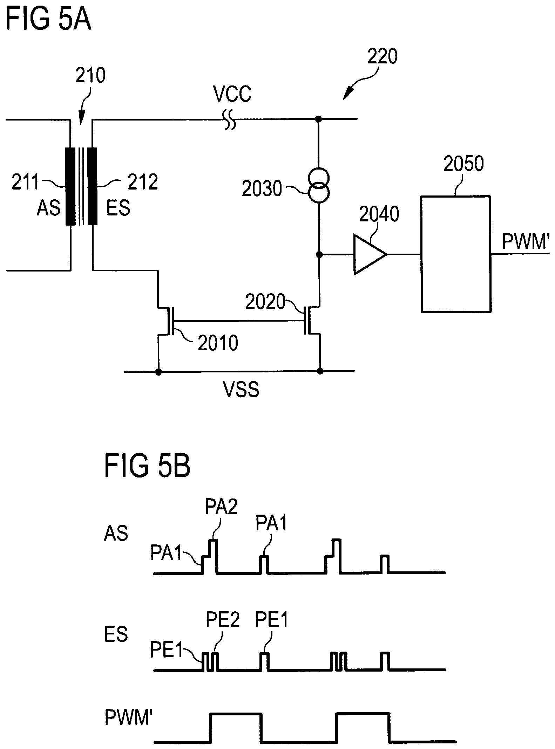

Figures 4A, 4B, 5A and 5B show the first embodiment of the transmitter and receiver device wherein a data signal is coded with different amplitudes which can then be detected to reconstruct the data signal. The signals may be generated as current signals. Figure 4A shows an embodiment of a transmitter device 100 coupled between a supply potential VSU and a reference potential VSD. The transmitter device 100 comprises a current mirror circuit comprising transistors 1010, 1020 and 1030. The transistor 1010 and a current source 1060 are coupled between a supply potential VSU and a reference potential VSD. The transistors 1020 and 1030 may be coupled to a second current mirror comprising transistors 1040 and 1050 by switches 1070 and 1080. The second current mirror is connected to the primary side 211 of transformer 210. The switches 1070 and 1080 are controlled by the rising and falling edges of the digital signal PWM.

Figure 4B shows the digital signal PWM for controlling switches 1070 and 1080 and the output signal AS which is generated by the transmitter circuit 110 shown in Figure 4A. It is assumed that the transistors of the transmitter circuit 120 have the same width/length relationship. When the digital signal PWM has a rising edge the switch 1070 is at first turned from a non-conductive to a conductive state so that the output signal is generated with an amplitude PA1. After a short delay the switch 1080 is also turned from a non-conductive to a conductive state so that both transistors are operated in the conductive state. The transmitter circuit 120 generates the output signal AS with an amplitude PA2 being higher than the amplitude PA1. The amplitude PA2 may be twice as high as the amplitude PA1. As a result, the transmitter circuit 120 generates the output signal AS with a sequence of two different amplitudes PA1, PA2, when the rising edge of the digital signal PWM is applied to the input side E120 of the transmitter circuit 120. The transmitter circuit 120 is further configured to generate the output signal AS with one amplitude PA1, when the falling edge of the digital signal PWM is applied to the input side E120 of the transmitter circuit 120.

According to the embodiment of the transmitter circuit 120 shown in Figure 4A, the digital signal PWM is coded in a current pattern comprising a sequence of amplitudes PA1, PA2, when the digital signal PWM has a rising edge and having only one amplitude PA1, when the digital signal PWM has a falling edge. As shown in Figure 5B the transformer 210 generates the input signal ES with a sequence of two signal peaks PE1, PE2 applied to the input side E220 of the receiver circuit 220 when the sequence of the two amplitudes PA1, PA2 is applied to the primary side of the transformer 210, and the transformer 210 generates the input signal ES for the receiver circuit 220 with only one signal peak PE1 when the output signal AS is generated by the transmitter circuit 120 with the sole amplitude PA1.

The output signal AS and the input signal ES may be current signals. The amplitude PA1 may correspond to a current I_{L} and the amplitude PA2 may correspond to a current of 2 * I_{L}. Each of the current peaks PE1, PE2 may have an amplitude of I_{L}. When the output signal AS is generated with a current change of I_{L}, the current peak I_{L} is induced to the secondary side 212 of the transformer 210. After a delay, when the output signal changes by the current amplitude I_{L} again, a current of I_{L} is induced and detected again in the secondary side 212 of transformer 210. That means, the current amplitude of I_{L} is detected twice in a defined duration for the rising edge of the digital signal and the current amplitude of I_{L} is detected only one time for the falling edge of the digital signal PWM.

These patterns for the rising and falling edges of the digital signal PWM can be interchangeable also. The magnitude and pattern of currents chosen for this scheme can be chosen to any two different values of current depending on the sensitivity of the receiver, the coupling efficiency of the coils and noise margins needed in the design.

Figure 5A shows an embodiment of the receiver circuit 220 which is configured to generate the rising and falling edge of the reconstructed digital signal PWM' in dependence on detecting the sequence of the two signal peaks PE1, PE2 or the one signal peak PE1. The receiver circuit 220 is coupled between a supply potential VCC and a reference potential VSS and comprises a current mirror of transistors 2010, 2020 which are coupled to the secondary side 212 of transformer 210. A reference current generated by a current source 2030 and the output signal of the current mirror is compared in a comparator 2040. The comparator 2040 is connected to a signal pattern detector 2050 which generates the reconstructed digital signal PWM' in dependence on the detected pattern of the sequence of the peaks PE1, PE2 or the one peak PE1. The current peaks PE1 and PE2 have an amplitude of I_{L}. The current source 2030 may be configured to generate a reference current of 0.5 * I_{L}. As shown in Figure 5B, the receiver circuit 220 generates the digital signal PWM' with a rising edge when the receiver circuit 220 detects the two subsequent current peaks PE1, PE2 at the input side E220, and the receiver circuit 220 generates the digital signal PWM' with a falling edge when the receiver circuit 220 detects the sole current peak PE1 at the input side E220.

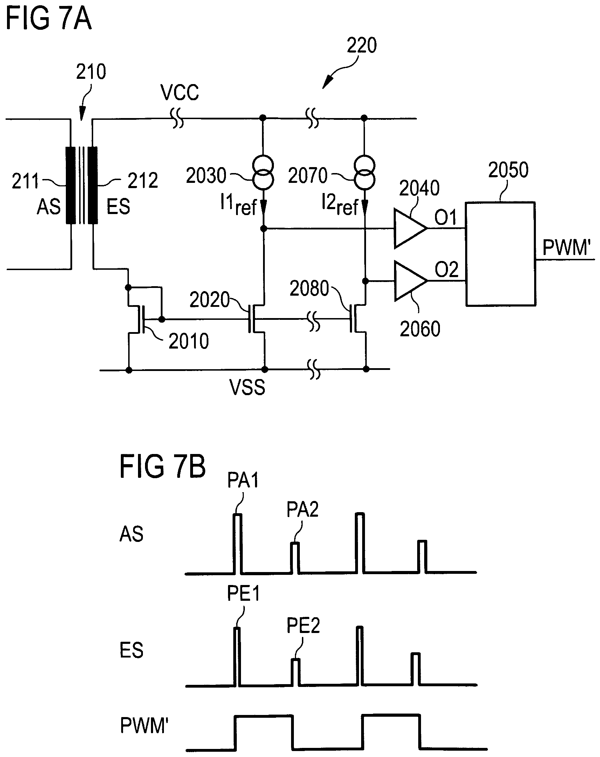

Figures 6A, 6B show an embodiment of the transmitter circuit 120 wherein the data is coded such that the magnitude of a signal indicates the data transmitted. The transmitter circuit may be coupled between a supply potential VSU and a reference potential VSD. Figures 7A, 7B show a receiver circuit 220 to generate the reconstructed digital signal PWM' in dependence on the magnitude of the signal detected at the receiver input side. The receiver circuit 220 is connected between a supply potential VCC and a reference potential VSS. The signals may be generated as current signals.

According to the embodiment of the receiver circuit 120 shown in Figure 6A, the receiver circuit comprises a first current mirror formed by transistors 1010, 1020 and 1030. The transistors 1020 and 1030 may be connected to a second current mirror comprising transistors 1040 and 1050 by switches 1070 and 1080. A reference current is generated by a current source 1060. The second current mirror is connected to the primary side 211 of transformer 210 to apply the output signal AS to the primary side of the transformer.

Figure 6B shows the digital signal PWM and the output signal AS generated by the transmitter circuit 120, if it is assumed that the ratio of the width to the length of transistor 1030 is twice as high the ratio of the width to the length of transistor 1020. The switches 1070 and 1080 are controlled by the rising and falling edges of the digital signal PWM. The transmitter circuit 120 is configured to generate the output signal AS with one first amplitude PA1 when a rising edge of the digital signal is applied to the input side E120 of the transmitter circuit 120. The transmitter circuit 120 is further configured to generate the output signal AS with one second amplitude PA2 being different from the first amplitude PA1 when a falling edge of the digital signal PWM is applied to the input side E120 of the transmitter circuit 120.

The rising edge of the digital signal PWM turns the switch 1080 in a conductive state, wherein the switch 1070 is operated in an open state. The falling edge of the digital signal PWM turns the switch 1070 in a conductive state and the switch 1080 in a non-conductive state. Due to the different ratios of the width to the length of transistors 1030 and 1020, the amplitude PA1 of the output signal AS can be higher than the amplitude PA2.

Figure 7A shows an embodiment of the receiver circuit 220 coupled to the transformer 210. The receiver circuit 220 is formed by a current mirror comprising transistors 2010, 2020 which are coupled to the secondary side 212 of transformer 210. A current source 230 generates a reference current I1_{ref} and a current source 2040 of the receiver circuit 220 generates a reference current I2_{ref}. A comparator 2040 is provided to compare the current of the input signal ES with the reference current I1_{ref}. A comparator 2060 is provided to compare the current of the input signal ES with the reference current I2_{ref}. A logic circuit 2050 is connected to the output side of the comparators 2040, 2060 to generate the reconstructed digital signal PWM'.

The function of the receiver circuit 220 is illustrated in Figure 7B. As explained with reference to Figures 6A and 6B the output signal AS of the transmitter circuit 120 is generated with different amplitudes PA1, PA2 in dependence on a rising or falling edge of the digital signal PWM. The transformer 210 is configured to generate the input signal ES with the amplitudes PE1 and PE2, wherein amplitude PE1 is twice as high as the amplitude PE2 according to the applied output signal AS having the amplitude PA1 being twice as high as the amplitude PA2. The current source 230 may generate the reference current I1_{ref} with an amplitude of I_{L}/2, and the current source 2070 may generate the reference current I2_{ref} with an amplitude of 3 * I_{L}/2. If it is assumed, that the input signal ES has an amplitude PA1 of 2 * I_{L} and an amplitude PA2 of I_{L}, the comparator 2040 compares the input current ES of 2 * I_{L} with the reference current I1_{ref} = I_{L}/, and the comparator 2060 compares the input current ES with the reference current I2_{ref} = 3 * I_{L}/2.

The comparators 2040 and 2060 may be configured so that both of their output signals O1, O2 are generated with a low level, when the rising edge of the digital signal is transmitted and the amplitude of the input signal ES is higher than the amplitudes of the reference currents I1_{ref}, I2_{ref}. When the input signal ES has the amplitude PA2 of I_{L}, the comparators 2040, 2060 may generate the signal O1 with a low level and the signal O2 with a high level indicating that the falling edge of the digital signal is transmitted. The logic circuit 2050 is configured to reconstruct the data waveform transmitted based on the state of the signals O1 and O2.

The magnitude of currents for the rising and the falling edges of the digital signal PWM can be interchangeable also with this second scheme of the transmitter and receiver circuit. The magnitude of currents provided for this scheme can be chosen as any two different values of current depending on the sensitivity of the receiver, the coupling efficiency of the coils and noise margins needed in the design.

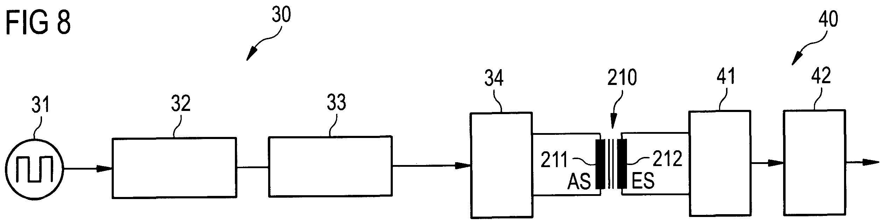

Figure 8 shows a block diagram of a communication channel comprising an input transmitter stage 30 and an output receiver stage 40 which are coupled by the transformer 210. The input stage comprises a data generation circuit 31 which is coupled to a noise/glitch filter 32 and an edge detector circuit 33. The edge detector circuit 33 is connected to a primary coil driver 34 which is coupled to the input side 211 of the transformer 210. The secondary side 212 of the transformer 210 is coupled to an edge detector circuit 41 and a signal receiver to output a reconstructed data signal.

The transmitter stages are configured to generate the output signal AS so that an input signal ES is generated at the secondary side 212 of the transformer 210 with a short pulse whenever the digital signal PWM has a rising or falling edge. The receiver stages are configured to detect the edge information of the input signal ES and to generate the reconstructed digital signal PWM', if it is assumed that the duty-cycle of the digital signal PWM has a duty-cycle of less than 50%. The receiver stages are configured to compute the duty-cycle to generate the reconstructed digital signal PWM' which is then used to control the fly-back converter.

Figure 9 shows an embodiment of the receiver circuit 220 comprising a comparator circuit 3100 to output a control signal c1_xnor_c1d and a comparator circuit 3200 to output a control signal c2_xnor_c2d. The control signals c1_xnor_c1d and c2_xnor_c2d are applied to an evaluation circuit 3300 to generate the reconstructed digital signal PWM' based on the control signals c1_xnor_c1d and c2_xnor_c2d. The receiver circuit 220 further comprises a control circuit 3400 to generate control signals S1, S2, S3 and S4, a clock generation circuit 3500 to generate clock signals c1_clk, c2_clk, a control circuit 3600 to generate control signals S5, S6 and a reset signal generator to generate a reset signal RS.

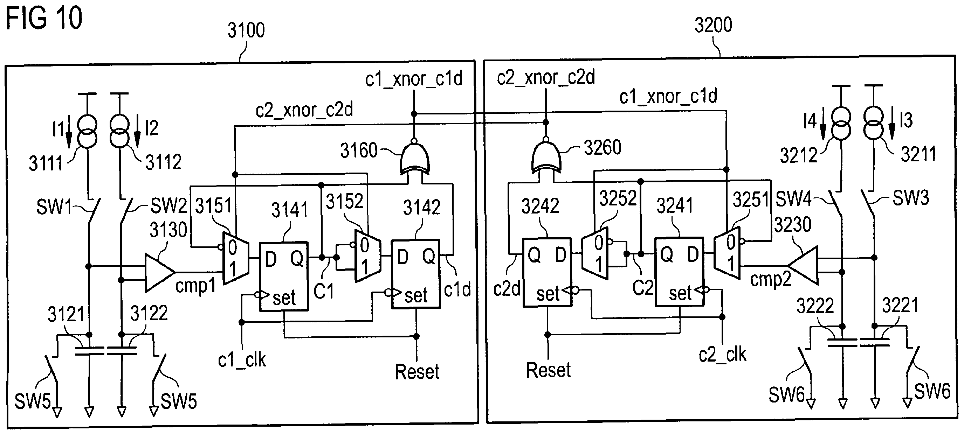

Figure 10 shows an embodiment of the comparator circuits 3100 and 3200 in a detailed illustration. The comparator circuit 3100 comprises a current source 3111 for generating a current I1 and a current source 3112 for generating a current 12. Both currents may be applied to a comparator 3130 when switches SW1 and SW2 are operated in a conductive state. Comparator 3130 compares the charges stored on capacitors 3121 and 3122. Switches SW5 are provided to discharge the capacitors. The comparator 3130 generates a comparison signal cmp1 which may be applied to a latching unit comprising a chain of logic block 3151, flipflop 3141, logic block 3152 and flipflop 3142. The comparison signal cmp1 is latched in the latching unit using the clock signal c1_clk. The output of flipflop 3141 generates a signal c1 and the output of flipflop 3142 generates a signal c1d which is applied to an XNOR logic block 3160 to generate the control signal c1_xnor_c1d.

The comparator circuit 3200 is formed in a similar way as comparator circuit 3100. The comparator circuit 3200 comprises current sources 3211 and 3212 to generate currents I3 and 14. In a conductive state of switches SW3 and SW4 capacitors 3221 and 3222 are charged by the currents I3 and 14. In a non-conductive state of switches SW6, a comparator 3230 compares the charges stored on capacitors 3221 and 3222 and generates comparison signal cmp2. The capacitors 3221 and 3222 may be discharged by switching the switches SW6 in a conductive state. The comparison signal cmp2 is applied to a latching unit comprising a series connection of a logic block 3251, a flipflop 3241, a logic block 3252 and flipflop 3242. The comparison signal cmp2 is latched in the latching unit using the clock signal c2_clk. The flipflop 3241 generates an output signal c2 and the flipflop 3242 generates an output signal c2d which are both applied to an XNOR logic block 3260.

The logic block 3160 of comparator circuit 3100 generates the control signal c1_xnor_c1d which is fed back to logic blocks 3251, 3252 of comparator circuit 3200. The logic block 3260 generates the control signal c2_xnor_c2d which is fed back to logic blocks 3151 and 3152.

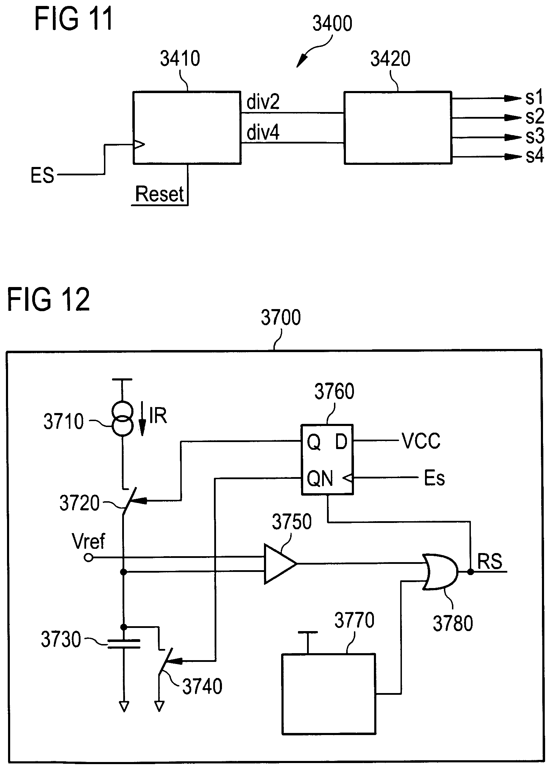

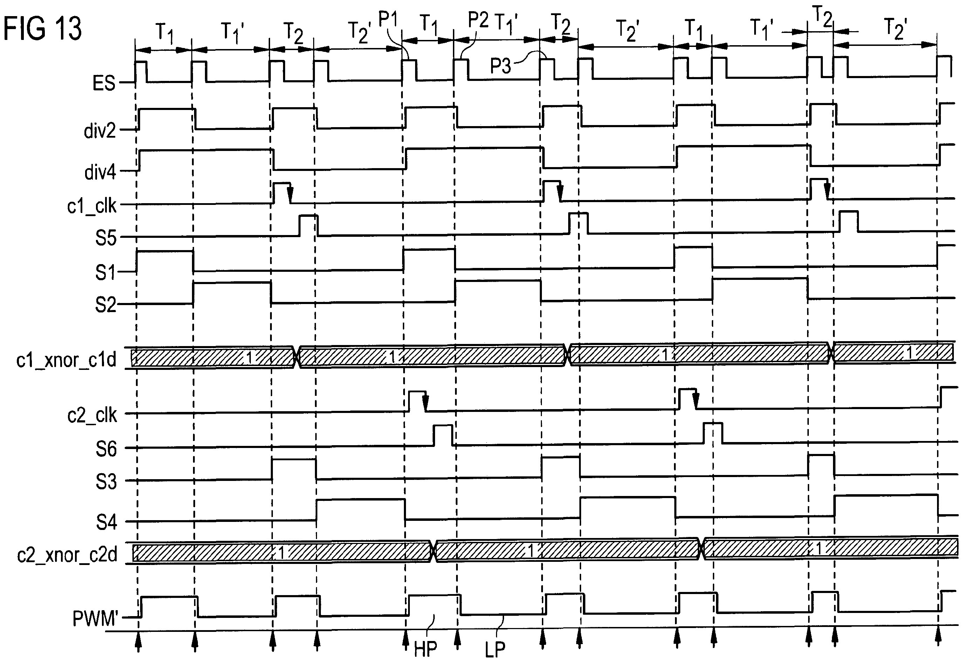

Figure 11 shows an embodiment of a control circuit 3400 to generate the control signals S1, ..., S4 to control switches SW1, ..., SW4. The control circuit 3400 comprises a counter circuit 3410 which may be formed as a 2-bit down counter. The counter circuit has an input terminal to apply the input signal ES, a reset terminal to apply the reset signal RS and output terminals to generate control signals div2 and div4. The control circuit 3400 further comprises a control signal generation circuit 3420 which generates the control signals S1, ..., S4 in dependence on the control signals div2 and div4. The generation of the control signals div2 and div4 as well as the generation of the control signals S1, ..., S4 is explained below with reference to Figure 13.

Figure 12 shows an embodiment of the generator circuit 3700 to generate the reset signal RS. The reset generator circuit 3700 comprises a current source 3710 to generate a current IR which is used to charge a capacitor 3730 when a switch 3720 is operated in a conductive state. Capacitor 3730 may be discharged by turning a switch 3740 in a conductive state. The switches 3720 and 3740 are controlled by a flipflop 3760. The clock pin of the flipflop 3760 is connected to the input signal ES,and the D-pin is connected to voltage VCC. A comparator 3750 compares a reference potential Vref with the charge stored at the capacitor 3730. An output side of comparator 3750 is coupled to an input side of an OR logic block 3780. Another input side of the OR logic block 3780 is coupled to a circuit block 3770. The circuit block 3770 is a Power on Reset block which generates a signal, if power is applied. The reset signal RS is generated at the output side of the logic block 3780.

The function of the receiver circuit 220 shown in Figure 9 is explained with reference to the signal diagram shown in Figure 13. The transmitter circuit 120 and the transformer 220 are formed so that the input signal ES is applied to the receiver circuit 220 with signal pulses for each one of a rising and falling edge of the digital signal PWM applied to the transmitter circuit 120. The receiver 220 is built on the principle of comparison of the time between three consecutive pulses of the input signal ES. The signal diagram of Figure 13 shows pulses P1, P2 and P3 of the input signal ES applied to the receiver circuit 220 of Figure 9. If it is assumed that the duty-cycle of the digital signal PWM is always less or equal than 50%, a comparison of times T₁, T₁' between the consecutive pulses P1, P2 and P3 may be utilized to take the decision which one of the pulses P1, P2 and P3 corresponds to the rising and falling edge of the digital signal PWM to then generate the reconstructed digital signal PWM'.

The counter circuit 3410 generates control signals div2 and div4 as shown in Figure 13 with a different signal period. The control signal div2 changes its state whenever a signal pulse occurs in the course of the input signal ES. The control signal div4 changes its state at every second pulse of the input signal ES. The control circuit 3420 generates the control signal S1 according to a logic function S1 = (div4 + div2), the control signal S2 according to a logic function S2 = (div4 +/div2), the control signal S3 according to a logic function S3 = (/div4 + div2) and the control signal S4 according to a logic function S4 = (/div4 +/div2), where "/" denotes the inverse of the signal div2, div4.

The pulse P1 of the input signal ES which may correspond to a rising or falling edge of the digital signal PWM will turn the switch SW1 in the conductive state to charge capacitor 3121. Upon the detection of the next edge P2 of the input signal ES, switch SW1 will be turned in a non-conductive state and switch SW2 will be turned in a conductive state. Until the next edge P3 of the input signal ES is received, capacitor 3122 is charged. If the time T₁ between signal pulses P1 and P2 is less than the time T₁' between signal pulses P2 and P3, then the comparator 3130 generates the comparison signal cmp1 with a first state indicating that the first signal pulse P1 corresponds to the rising edge of the digital signal, since it is assumed that the duty-cycle of the digital signal is less than 50%. If the time T₁ between the first and second signal pulse P1, P2 is greater than the time T₁' between the second and third signal pulse P2, P3, the comparison signal cmp1 is generated by the comparator 3130 with a second state. The second state indicates that the second signal pulse corresponds to the rising edge of the digital signal PWM, since the duty-cycle of the digital signal is less than 50%.

According to the embodiment of the receiver circuit shown in Figure 9, the receiver circuit is configured to detect the first time duration T₁ between the first and a second signal pulse P1, P2, wherein the second signal pulse P2 is applied to the receiver circuit 220 subsequently in relation to the first signal pulse P1. Furthermore, the receiver circuit 220 is configured to detect the second time duration T₁' between the signal pulse P2 and the signal pulse P3, wherein the signal pulse P3 is applied to the receiver circuit 220 subsequently in relation to the signal pulse P2. The receiver circuit 220 is configured to compare the time duration T₁ and T₁'. The receiver circuit 220 generates the reconstructed digital signal PWM' with a high pulse HP for the time duration T₁ and with a low pulse LP for the time duration T₁', when the receiver circuit detetects that the time duration T₁ is shorter than the time duration T₁'. On the other hand, the receiver circuit 220 generates the reconstructed digital signal PWM' with a high pulse HP for the time duration T₁' and with a low pulse LP for the time duration T₁, when the time duration T₁' is shorter than the time duration T₁.

The generator circuit 3700 to generate the reset signal RS is needed to turn off the receiver block when no transmission of a digital signal PWM is received for a certain time duration. This time duration can be selected as twice the maximum time period of the digital signal to be transmitted. The control signal RS is also asserted on power-ON to define the internal logic in a defined state. The first signal pulse of the input signal ES after the reset signal RS is de-asserted will be considered as the high pulse of the waveform of the digital signal.

As shown in Figure 10 and Figure 13 the two comparator circuits 3100 and 3200 are used in alternating cycles so that there is no delay in the receiver circuit 220. This scheme is also robust in relation to any external stray field which might cause a glitch on the secondary side of the transformer, since a rising edge of the input signal is computed and alternating cycles use the comparator circuits 3100 and 3200. The receiver circuit enables to recover the digital signal from any stray disturbance within a couple of cycles.

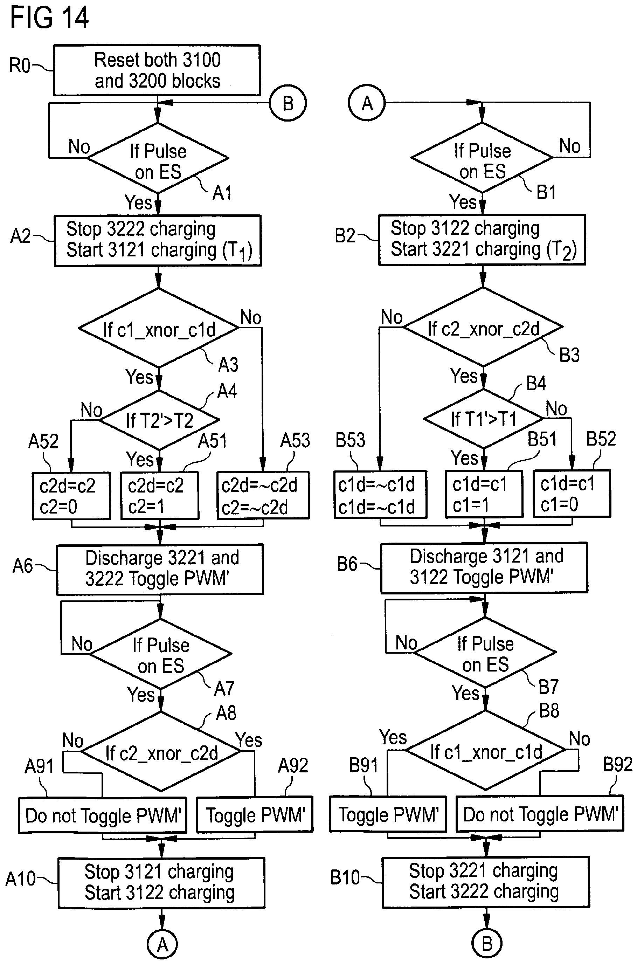

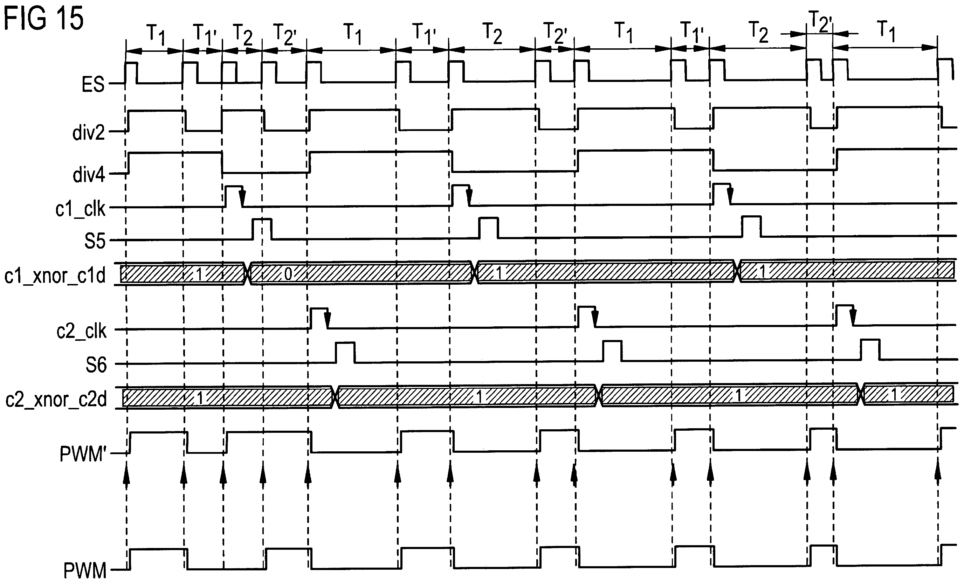

Figure 14 shows an algorithm to toggle the reconstructed digital signal PWM' between a high pulse HP and a low pulse LP as shown in the diagram of Figure 15 which enables to correct an error caused by a glitch in the input signal ES. According to the algorithm shown in Figure 14, both comparators circuits 3100 and 3200 are operated in a reset state (step R0). According to steps A1 and A2, if a signal pulse on the input signal ES occurs, the charging of capacitor 3222 is stopped and the charging of capacitor 3121 is started. In step A3 the signal state of the control signal c1_xnor_c1d is monitored. If the control signal c1_xnor_c1d is output with a state "1" and, according to step A4, if the time duration T₂' is greater than the time duration T₂, the state of the flipflop 3242 is set to c2 and the state of the flipflop 3241 is set to "1" (step A51). If the time duration T₂' is not greater than T₂, the flipflop 3242 is set to the state c2 of the flipflop 3241 and the flipflop 3241 is set to "0" (step A52). If the state of the control signal c1_xnor_c1d is not equal to "1", the flipflops 3241 and 3242 are set to /c2d (step A53). In the next step A6, capacitor 3221 and capacitor 3222 are discharged and the reconstructed digital signal PWM' is toggled. If the input signal ES shows a next pulse (step A7) and if the control signal c2_xnor_c2d has the state "1" (step A8) the reconstructed digital signal PWM' is toggled again. If the control signal c2_xnor_c2d does not have the state "1", the reconstructed digital signal PWM' is not toggled. After that, according to step A10, a charging of capacitor 3121 is stopped and a charging cycle of capacitor 3122 is started.

If a next pulse of the input signal ES is detected (step B1), the charging of capacitor 3122 is stopped and a charging of capacitor 3221 is started (step B2). If the control signal c2_xnor_c2d has the state "1" (step B3) and if the time duration T₁' is greater than T₁ (step B4), the flipflop 3142 stores the state c1 of the flipflop 3141 and the flipflop 3141 stores the state "1" (step B51). If the time duration T₁' is not greater than T₁, the flipflop 3142 stores the state c1 stored before in flipflop 3141 and the state of flipflop 3141 is set to "0" (step B52). If the control signal c2_xnor_c2d does not have the state "1", the flipflops 3141 and 3142 are set to /c1d (step B53). In a next step B6, the capacitors 3121 and 3122 are discharged and the reconstructed digital signal PWM' is toggled. If the input signal ES has a next pulse (step B7) and if the control signal c1_xnor_c1d has the state "1" (step B8), the reconstructed digital signal PWM' is toggled (B91). If the control signal c1_xnor_c1d does not have the state "1", the reconstructed digital signal PWM' is not toggled (step B92). In a subsequent step B10 capacitor 3222 and capacitor 3221 are charged again.

As shown in Figure 15, the input signal ES shows a glitch in the time duration T₂. The built-in glitch correction algorithm shown in Figure 14 ensures that the waveform of the reconstructed digital signal PWM' aligns to the transmitted digital signal PWM within one cycle.

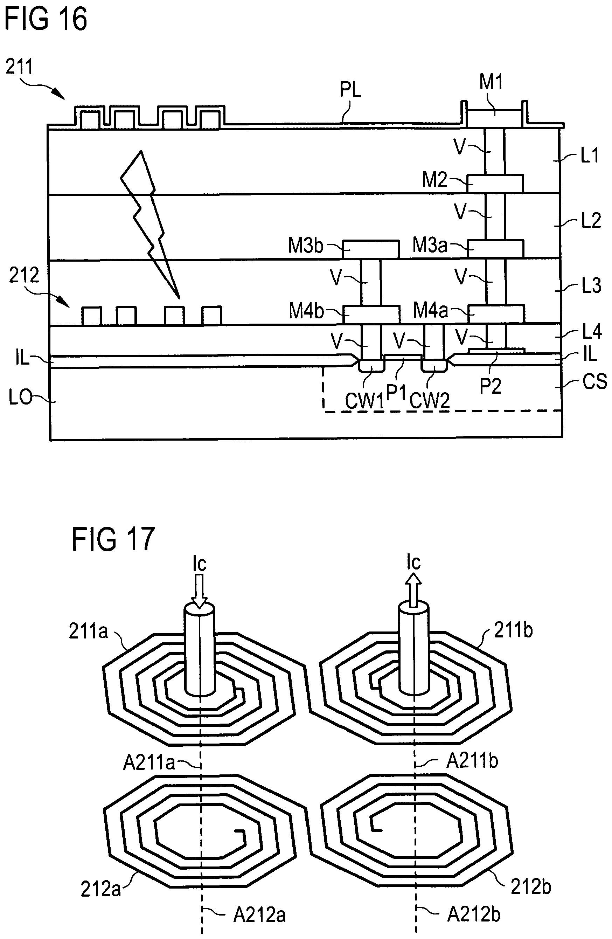

Figure 16 shows a cross-section through a chip comprising the transformer 210 with a primary transmitter coil 211 and a secondary receiver coil 212. The chip comprises a substrate L0, for example a material of silicon, on which a plurality of dielectric layers L1, L2, L3 and L4 of a silicon oxide material are disposed. According to the embodiment shown in Figure 16 the receiver coil is integrated in a silicon oxide layer L3 and the primary coil is disposed on the top surface of the silicon oxide layer L1. A passivation layer PL is disposed over the surface of the layer L1 and the coil windings of the primary coil 211. The isolator comprising the primary coils 211 separated from the secondary coils by inter metal dielectric layers L1, L2 and L3 is integrated in a one-chip solution together with standard CMOS devices.

As an example for a standard CMOS device, CMOS wells CW1 and CW2 are embedded in the substrate L0. An isolation layer IL is disposed on the surface of the substrate L0. Layers of polysilicon P1 and P2 are disposed on the surface of the substrate L0 between CMOS wells CW1 and CW2 and on the surface of the isolation layer IL. Metal layers M1, M2, M3a, M4a, M3b, M4b are disposed on each surface of the dielectric layers L1, L2, L3 and L4. The metal layers are connected by via holes V.

The design shown in Figure 16 combines a galvanic isolator with devices and circuits of a conventional CMOS technology. The galvanic isolator comprises the transmitter connected coil 211, the receiver connected coil 212 and the isolator arranged there between. The galvanic isolator is used for electrical data transfer with signal voltage levels which can differ by several hundred Volts during operation. The transmitter connected primary coil 211 and the receiver connected coil 212 are realised in a standard CMOS technology including standard vias with a depth smaller than 2pm. The minimum dimensions and the minimum spacings of all metal lines and via holes are not changed with respect to the CMOS base technology.

Therefore, on the one hand, the integration density is the same as for the base CMOS technology. On the other hand, a high galvanic isolation capability can be achieved with the structure shown in Figure 16. Additional backend layers, such as silicon oxide, polyimide, or additional levels of metal, are not required.

As mentioned above, a very large electrical potential difference of several hundred Volts can occur between the transmitter device at the primary side of the transformer and the receiver device at the secondary side of the transformer over a long period of time, for example up to 15 years. In order to guarantee a reliable electrical isolation between the primary side 211 and the secondary side 212 of the transformer 210, a dielectric isolation which is used in a conventional CMOS technology may be provided between the metal layer 211 of the primary coil and the metal layer 212 of the secondary coil. Silicon dioxide which is used in the mature CMOS technology as an intermetal dielectric can be used for this purpose. The dielectric strength of this material is typically about 8 MV/cm. A dielectric layer of a thickness of greater than 6.5 µm is sufficient to ensure a voltage rating of 2.5 kVrms for 1 minute. This thickness can be provided in a 4 level metal process, if the thickness of each intermetal oxide layer is about 2.4 µm. The thickness is increased with respect to the pure standard CMOS process, but it is small enough that conventional process steps, such as via etching, can be utilized without major process changes. The aspect ratio of the VIA holes may be about 4 in these cases. This can be accomplished by a standard VIA etch recipe of a 0.35 µm silicon technology. Other steps such as VIA resist mask exposure and development, VIA liner deposition and tungsten fill can be taken from the base process.

As shown in Figure 16 the distance between the metal layer M1, M2, M3a/M3b, M4a/M4b is the same. Standard resist masks and VIA etch recipes can be utilised, because the overall thickness is equally distributed among all inter metal dielectric layers.

Mechanical stress is an important issue for a backend technology with an increased overall oxide thickness. This is due to the different thermal expansion coefficients of silicon and silicon oxide. The stress can be reduced to an acceptable level by decreasing the low and high frequency power of the plasma in the plasma enhanced chemical vapour deposition process.

A criterion which is frequently met is the requirement of 2500 Volt root mean square (rms) which has to be withstood by the structure for 60 seconds. A more detailed specification of the electrical requirements can be found in the industry standards VDE V 0884-10 and DIN EN60747-5-2. The on-chip galvanic isolation solution shown in Figure 16 offers 2.5 kVrms, 60s voltage rating with a single chip solution without additional processing steps. There is no need for costly via etching modules, for example double resist coating. For all layers of metal the design rules do not change.

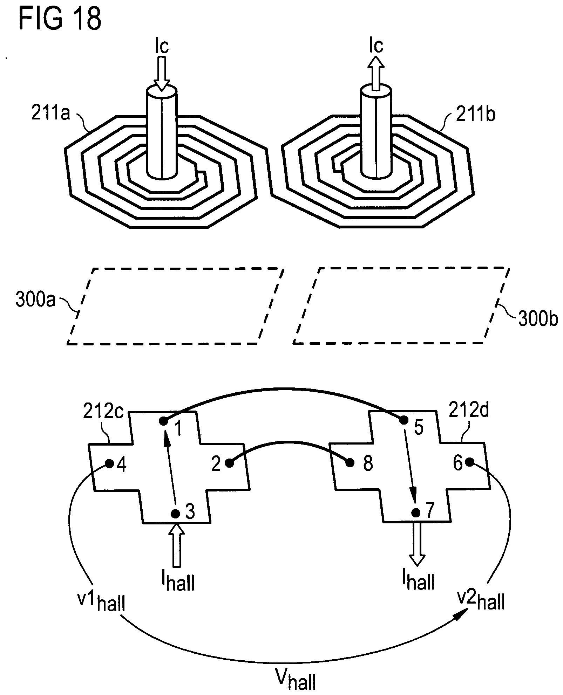

According to embodiments of the transformer structure shown in Figures 17 and 18 and not being part of the present claims, a pair of coils 211a, 211b is used as primary coils of the primary side of the transformer coupled to the transmitter device. The coils 211a, 211b are connected in series and have a different sense of winding, so that in each coil the absolute current flow I_{c} is the same. Both coils have the same dimensions and geometry but their windings are clock- and anticlockwise, respectively. Therefore, the magnetic flux through the secondary coils 212a and 212b is the same. However, the components of the magnetic induction which are parallel to the axis A212a and A212b have opposite values in the center of the receiver coils 212a and 212b.

According to the embodiment of the secondary side of the transformer shown in Figure 17 the secondary side 212 comprises a pair of in- series connected coils 212a, 212b which again have a different sense of winding just like the transmitting coils 211a, 211b. Both, the transmitter coils 211a, 211b and the receiver coils 212a, 212b are positioned exactly on top of each other. The first pair of coils 211a, 211b and the second pair of coils 212a, 212b are positioned such that a respective axis A211a, A211b of one of the coils 211a, 211b of the first pair of coils and a respective axis A212a, A212b of one of the coils 212a, 212b of the second pair of coils are aligned on top of each other.

If a current is forced through the transmitter device, an equal magnetic flux is generated through both coils 211a, 211b as they are equal in shape and connected in series. However, due to the fact that the sense of winding is opposite, the normal components of the magnetic field have opposite directions. A current which varies with time thus leads to an opposite magnetic induction in the receiver connected coils 212a, 212b which are positioned underneath. Due to the fact that the sense of winding of the receiving coils 212a, 212b is also opposite, the induced currents and the induced potential differences add up. Therefore, a non-steady current flowing in the primary side coils 211a, 211b can effectively generate a current flow in the secondary side coils 212a, 212b and information can be transferred. If on the other hand a non-steady external perturbing magnetic field is applied, it is effectively cancelled out. External magnetic fields normally have a small spatial gradient on the scale of the secondary coils, so that the same spurious magnetic field is "seen" from both coils. As both coils 212a, 212b are oppositely wound, the induced spurious signals are effectively cancelled.

Figure 18 shows another embodiment of the primary and secondary side of a transformer. The primary side of the transformer comprises the first pair of in-series connected coils 211a, 211b and the secondary side 212 comprises Hall sensors 212c, 212d. The Hall sensors 212c, 212d are configured to be sensitive to a direction of a normal component of a magnetic induction generated by the first pair of coils 211a, 211b, if a current flows in the first pair of coils 211a, 211b.

The Hall sensors 212c, 212d are sensitive to the normal component of the magnetic induction B_{z}. The Hall sensors are also sensitive to the sign of B_{z}. Each Hall sensor element 212c, 212d is positioned directly under each coil 211a, 211b. The middle of each Hall sensor 212c, 212d coincides with the axis of the coils 211a, 211b. The shape, the adjustment and the electrical connections of the Hall sensors are shown schematically in Figure 18.

Each of the Hall sensor elements 212c, 212d comprises at least a first electrode 1, 5, a second electrode 2, 8, a third electrode 3, 7 and a fourth electrode 4, 6. The first electrodes 1, 5 of the first and second Hall sensor elements 212c, 212d are connected to each other. The second electrodes 2, 8 of the first and second Hall sensor elements 212c, 212d are connected to each other. A current Iₕₐₗₗ flows from the second electrode 3 of the Hall sensor element 212c to the first electrode 1 of the Hall sensor element 212c and from the first electrode 5 of the Hall sensor element 212d to the second electrode 7 of the Hall sensor element 212d. A voltage drop Vₕₐₗₗ occurs between the fourth electrode 4 of the Hall sensor element 212c having a voltage potential V1ₕₐₗₗ and the fourth electrode 6 of the Hall sensor element 212d having a voltage potential V2ₕₐₗₗ, when the current I_{c} flows in the first pair of coils 211a, 211b. The electrodes 1, 2, 3, 4, 5, 6, 7 of the Hall sensor elements 212c, 212d are arranged so that the current Iₕₐₗₗ flows in opposite directions in the Hall sensor elements 212c, 212d.

Each sensor 212c, 212d is driven by a constant current Iₕₐₗₗ. Between the electrodes 4 and 2 as well as 8 and 6 of the Hall sensor elements a potential difference can be measured which is proportional to the magnetic induction B_{z} and hence to the current I_{c} flowing in the coils 211a, 211b. The electrodes 2 and 8 are electrically connected. Between electrodes 4 and 6 a sum of two Hall voltages can therefore be measured. The current Iₕₐₗₗ flows in the opposite direction in each sensor 212c, 212d. Therefore, a uniform external field does not lead to a Hall voltage between terminal 4 and 6. If on the other hand a current I_{c} flows, the voltages between terminals 4-2 and 8-6 sum up to give twice the voltage of a single sensor. This means that the Hall sensor 212 has an improved signal to noise ratio. External magnetic fields are effectively cancelled out.

Furthermore, offset Hall voltages are reduced with this configuration. Real Hall sensors exhibit a small Hall voltage even in the absence of a magnetic field. The series connection of the terminals 2 and 8 reduces this offset together with the antiparallel current Iₕₐₗₗ.

Due to the large voltage difference which can occur between the coils 211a, 211b and the Hall sensors 212c, 212d it is advantageous to position electrical conductive shields above the Hall sensors. Figure 18 shows shields 300a, 300b arranged between the coils 211a, 211b of the primary transformer side and the Hall sensors 212c, 212d of the secondary transformer side. These shields are electrically connected to the ground level of the Hall sensors. They avoid that the conductivity of the well of the sensors is changed by the electric field caused by the coils.

### List of Reference Signs

- 10: transmitter stages
- 11: data generator
- 12: noise/glitch filter
- 13a: edge detector
- 13b: falling/rising edge detector
- 14: current controlled driver
- 20: receiver stages
- 21: current detector
- 22: comparator
- 30: transmitter stages
- 31: data generator
- 32: noise/glitch filter
- 33: edge detector
- 34: primary coil driver
- 40: receiver stages
- 41: edge detector
- 42: data reconstruction generator
- 100: transmitter device
- 110: detection circuit
- 120: transmitter circuit
- 200: receiver device
- 210: transformer
- 211: primary side of the transformer
- 212: secondary side of the transformer
- 220: receiver circuit
- 230: driver circuit
- 240: voltage regulator circuit
- 300: fly-back converter
- 400: battery pack
- 401, ..., 407: battery cells
- 500: voltage converter
- 3100: comparator circuit
- 3200: comparator circuit
- 3300: evaluation circuit
- 3400: control circuit
- 3500: clock generator circuit
- 3600: control circuit
- 3700: reset signal generator
- CH: chip
- PC: package
- PWM: digital signal
- AS: output signal
- ES: input signal
- PWM': reconstructed digital signal
- L0: substrate
- L1, ..., L4: dielectric layer
- M: metal layer
- V: via hole
- EL: isolation layer
- PL: passivation layer

## Claims

1. An electric circuit arrangement for galvanic isolated communication, comprising:
- a first battery pack (400a) comprising a plurality of first battery cells (401a, ... , 407a) and a second battery pack (400b) comprising a plurality of second battery cells (401b, ... , 407b),- a first transmitter device (100a) to monitor a charge condition of the first battery cells (401a, ..., 407a) and a second transmitter device (100b) to monitor a charge condition of the second battery cells (401b, ..., 407b), the first transmitter device (100a) including a detection circuit (110) to detect a charge condition of each of the first battery cells (401a, ..., 407a) and the second transmitter device (100b) including a detection circuit (110) to detect a charge condition of each of the second battery cells (401b, ..., 407b), the first and second transmitter devices (100a, 100b) respectively including a transmitter circuit (120) having an input side (E120) for applying a digital signal (PWM) and an output side (A120) for generating an output signal (AS) in dependence on the digital signal (PWM),
- a receiver circuit (220) having an input side (E220) for receiving an input signal (ES) and having an output side (A220) for generating a reconstructed digital signal (PWM') in dependence on the input signal (ES),
- a transformer (210) for inductive coupling the respective output side (A120) of the transmitter circuit (120) of the first and second transmitter devices (100a, 100b) to the input side (E220) of the receiver circuit (220), wherein the output side (A120) of the transmitter circuit (120) of the second transmitter device (100b) is coupled to the transformer (210) by means of the first transmitter device (100a),
- a charging circuit (300) to recharge the first battery cells (401a, ..., 407a) and the second battery cells (401b, ..., 407b), wherein the charging circuit (300) is coupled to the receiver circuit (220),
- wherein the first and second transmitter devices (100a, 100b) are operated in another voltage domain than the receiver device (200) and the charging circuit (300),
- wherein the respective detection circuit (110) of the first and second transmitter devices (100a, 100b) is configured to generate the digital signal (PWM), when the respecitive detection circuit (110) detects that the charge condition of one of the first battery cells (401a,... , 407a) and the second battery cells (401b, ..., 407b) is below a threshold value,
- wherein the respective transmitter circuit (120) of the first and second transmitter devices (100a, 100b) is configured to generate the output signal (AS) in dependence on the digital signal (PWM).

2. The electric circuit arrangement as claimed in claim 1,
- wherein the transformer (210) and the receiver circuit (220) are integrated in a first chip (CH1),
- wherein the transmitter circuit (120) is integrated in a second chip (CH2).

3. The electric circuit arrangement as claimed in any of claims 1 or 2,
wherein the transformer (210) and the receiver circuit (220) are housed in a first package (PC1), and the transmitter circuit (120) is housed in a second package (PC2), or wherein the transmitter circuit (120), the receiver circuit (220) and the transformer (210) are encapsulated in the same package.

4. The electric circuit arrangement as claimed in any of claims 1 to 3,
- wherein the transmitter circuit (120) is configured to generate the output signal (AS) with one first amplitude (PA1), when a rising edge of the digital signal (PWM) is applied to the input side (E120) of the transmitter circuit,
- wherein the transmitter circuit (120) is configured to generate the output signal (AS) with one second amplitude (PA2) being different from the one first amplitude, when a falling edge of the digital signal (PWM) is applied to the input side (E120) of the transmitter circuit.

5. The electric circuit arrangement as claimed in any of claims 1 to 4,
- wherein the transformer (210) is configured to generate the input signal (ES) with an amplitude (PE1, PE2) in dependence on the amplitude of the output signal (AS),
- wherein the receiver circuit (220) is configured to detect an amplitude of the input signal (ES) applied to the input side (E220) of the receiver circuit (220) and to generate the reconstructed digital signal (PWM') with a rising or falling edge in dependence on the detected amplitude of the input signal (ES).

6. The electric circuit arrangement as claimed in any of claims 1 to 5,
- wherein the transmitter circuit (120) is configured to generate the output signal (AS) with a sequence of at least two different amplitudes (PA1, PA2), when one of a rising and falling edge of the digital signal (PWM) is applied to the input side (E120) of the transmitter circuit,
- wherein the transmitter circuit (120) is configured to generate the output signal (AS) with at least one amplitude (PA1), when the other one of the rising and falling edge of the digital signal (PWM) is applied to the input side (E120) of the transmitter circuit (120).

7. The electric circuit arrangement as claimed in claim 6,
- wherein the transformer (210) is configured to generate the input signal (ES) with a sequence of at least two signal peaks (PE1, PE2), when the sequence of the at least two different amplitudes (PA1, PA2) is applied to the transformer (210),
- wherein the receiver circuit (220) is configured to generate the reconstructed digital signal (PWM') with one of the rising and falling edge, when the receiver circuit (220) detects the sequence of the at least two signal peaks (PE1, PE2) of the input signal (ES),
- wherein the transformer (210) is configured to generate the input signal (ES) with at least one signal peak (PE3), when the output signal (AS) is applied to the transformer with the at least one amplitude,
- wherein the receiver circuit (220) is configured to generate the reconstructed digital signal (PWM') with the other one of the rising and falling edge, when the receiver circuit (220) detects the at least one signal peak (PE3) of the input signal (ES).

8. The electric circuit arrangement as claimed in any of claims 1 to 7,
wherein the input signal (ES) and the output signal (AS) are current signals.

9. The electric circuit arrangement as claimed in any of claims 1 to 8,
wherein the transmitter circuit (120) and the transformer (210) are configured to generate the input signal (ES) with a signal pulse (P1, P2, P3) for each one of a rising and falling edge of the digital signal (PWM) applied to the transmitter circuit (120).

10. The electric circuit arrangement as claimed in claim 9,
- wherein the receiver circuit (220) is configured to detect a first time duration (T₁) between a first and a second signal pulse (P1, P2), the second signal pulse (P2) being applied to the receiver circuit (220) subsequently in relation to the first signal pulse (P1), and to detect a second time duration (T₁') between the second signal pulse (P2) and a third signal pulse (P3), the third signal pulse (P3) being applied to the receiver circuit (220) subsequently in relation to the second signal pulse (P2),
- wherein the receiver circuit (220) is configured to compare the first and second time duration (T₁, T₁'),
- wherein the receiver circuit (220) generates the reconstructed digital signal (PWM') with a high pulse (HP) for the first time duration (T₁) and with a low pulse (LP) for the second time duration (T₁'), when the first time duration (T₁) is shorter than the second time duration (T₁'), and
- wherein the receiver circuit (220) generates the reconstructed digital signal (PWM') with a high pulse (HP) for the second time duration (T₁') and with a low pulse (LP) for the first time duration (T₁), when the second time duration (T₁') is shorter than the first time duration (T₁) .

## Patentansprüche

1. Eine elektrische Schaltungsanordnung für eine galvanisch getrennte Kommunikation, umfassend:
- einen ersten Batteriesatz (400a) aufweisend eine Vielzahl von ersten Batteriezellen (401a, ..., 407a) und einen zweiten Batteriesatz (400b) aufweisend eine Vielzahl von zweiten Batteriezellen (401b, ..., 407b),
- eine erste Sendeeinrichtung (100a) zum Überwachen eines Ladezustands der ersten Batteriezellen (401a, ..., 407a) und eine zweite Sendeeinrichtung (100b) zum Überwachen eines Ladezustands der zweiten Batteriezellen (401b, ..., 407b), wobei die erste Sendeeinrichtung (100a) eine Detektorschaltung (110) zum Detektieren eines Ladezustands von jeder der ersten Batteriezellen (401a, ..., 407a) aufweist und die zweite Sendeeinrichtung (100b) eine Detektorschaltung (110) zum Detektieren eines Ladezustands von jeder der zweiten Batteriezellen (401b, ..., 407b) aufweist, wobei die erste und zweite Sendeeinrichtungen (100a, 100b) jeweils eine Sendeschaltung (120) mit einer Eingangsseite (E120) zum Anlegen eines digitalen Signals (PWM) und eine Ausgangsseite (A120) zum Erzeugen eines Ausgangssignals (AS) in Abhängigkeit von dem digitalen Signal (PWM) aufweist,
- eine Empfangsschaltung (220) mit einer Eingangsseite (E220) zum Empfang eines Eingangssignals (ES) und mit einer Ausgangsseite (A220) zur Erzeugung eines rekonstruierten digitalen Signals (PWM') in Abhängigkeit von dem Eingangssignal (ES),
- ein Übertrager zum induktiven Koppeln der jeweiligen Ausgangsseite (A120) der Sendeschaltung (120) der ersten und zweiten Sendeeinrichtungen (100a, 100b) zu der Eingangsseite (E220) der Empfangsschaltung (220), wobei die Ausgangsseite (A120) der Sendeschaltung (120) der zweiten Sendeeinrichtung (100b) über die erste Sendeeinrichtung (100a) mit dem Übertrager (220) gekoppelt ist,
- eine Ladeschaltung (300) zum Wiederaufladen der ersten Batteriezellen (401a, ..., 407a) und der zweiten Batteriezellen (401b, ..., 407b), wobei die Ladeschaltung (300) mit der Empfangsschaltung (220) gekoppelt ist,
- wobei die erste und zweite Sendeeinrichtung (100a, 100b) in einer anderen Spannungsdomäne als die Empfangseinrichtung (200) und die Ladeschaltung (300) betrieben werden,
- wobei die jeweilige Detektorschaltung (110) der ersten und zweiten Sendeeinrichtungen (100a, 100b) dazu ausgebildet ist, das digitale Signal (PWM) zu erzeugen, wenn die jeweilige Detektorschaltung (110) detektiert, dass der Ladezustand von einer der ersten Batteriezellen (401a, ..., 407a) und der zweiten Batteriezellen (401b, ..., 407b) unter einem Schwellwert liegt,
- wobei die jeweilige Sendeschaltung (120) der ersten und zweiten Sendeeinrichtungen (100a, 100b) dazu ausgebildet ist, das Ausgangssignal (AS) in Abhängigkeit von dem digitalen Signal (PWM) zu erzeugen.

2. Elektrische Schaltungsanordnung nach Anspruch 1,
- wobei der Übertrager (210) und die Empfangsschaltung (220) in einem ersten Chip (CH1) integriert sind,
- wobei die Sendeschaltung (120) in einem zweiten Chip (CH2) integriert ist.

3. Elektrische Schaltungsanordnung nach einem der Ansprüche 1 oder 2,
wobei der Übertrager (210) und die Empfangsschaltung (220) in einem ersten Gehäuse (PC1), und die Sendeschaltung (120) in einem zweiten Gehäuse (PC2) untergebracht sind, oder wobei die Sendeschaltung (120), die Empfangsschaltung (220) und der Übertrager (210) in demselben Gehäuse eingeschlossen sind.

4. Elektrische Schaltungsanordnung nach einem der Ansprüche 1 bis 3,
- wobei die Sendeschaltung (120) dazu ausgebildet ist, das Ausgangssignal (AS) mit einer ersten Amplitude (PA1) zu erzeugen, wenn eine steigende Flanke des digitalen Signals (PWM) an die Eingangsseite (E120) der Sendeschaltung angelegt wird,
- wobei die Sendeschaltung (120) dazu ausgebildet ist, das Ausgangssignal (AS) mit einer zweiten Amplitude (A2), die von der ersten Amplitude verschieden ist, zu erzeugen, wenn eine fallende Flanke des digitalen Signals (PWM) an die Eingangsseite (E120) der Sendeschaltung angelegt wird.

5. Elektrische Schaltungsanordnung nach einem der Ansprüche 1 bis 4,
- wobei der Übertrager (210) dazu ausgebildet ist, das Eingangssignal (ES) mit einer Amplitude (PE1, PE2) in Abhängigkeit von der Amplitude des Ausgangssignals (AS) zu erzeugen,
- wobei die Empfangsschaltung (220) dazu ausgebildet ist, eine Amplitude des an die Eingangsseite (E220) der Empfangsschaltung (220) angelegten Eingangssignals (ES) zu detektieren und das rekonstruierte digitale Signal (PWM') in Abhängigkeit von der detektierten Amplitude des Eingangssignals (ES) mit einer steigenden oder fallenden Flanke zu erzeugen.

6. Elektrische Schaltungsanordnung nach einem der Ansprüche 1 bis 5,
- wobei die Sendeschaltung (120) dazu ausgebildet ist, das Ausgangssignal (AS) mit einer Folge aus wenigstens zwei unterschiedlichen Amplituden (PA1, PA2) zu erzeugen, wenn eine der steigenden und fallenden Flanke des digitalen Signals (PWM) an die Eingangsseite (E120) der Sendeschaltung angelegt wird,
- wobei die Sendeschaltung (120) dazu ausgebildet ist, das Ausgangssignal (AS) mit wenigstens einer Amplitude (PA1) zu erzeugen, wenn die andere der einen steigenden und fallenden Flanke des digitalen Signals (PWM) an die Eingangsseite (E120) der Sendeschaltung (120) angelegt wird.

7. Elektrische Schaltungsanordnung nach Anspruch 6,
- wobei der Übertrager (210) dazu ausgebildet ist, das Eingangssignal (ES) mit einer Folge von wenigstens zwei Signalspitzen (PE1, PE2) zu erzeugen, wenn die Folge der wenigstens zwei unterschiedlichen Amplituden (PA1, PA2) an den Übertrager (210) angelegt wird,
- wobei die Empfangsschaltung (220) dazu ausgebildet ist, das rekonstruierte digitale Signal (PWM') mit einer der steigenden und fallenden Flanke zu erzeugen, wenn die Empfangsschaltung (220) die Folge aus den wenigstens zwei Signalspitzen (PE1, PE2) des Eingangssignals (ES) detektiert,
- wobei der Übertrager (210) dazu ausgebildet ist, das Eingangssignal (ES) mit wenigstens einer Signalspitze (PE3) zu erzeugen, wenn das Ausgangssignal (AS) mit der wenigstens einen Amplitude an den Übertrager angelegt wird,
- wobei die Empfangsschaltung (220) dazu ausgebildet ist, das rekonstruierte digitale Signal (PWM') mit der einen der steigenden und fallenden Flanke zu erzeugen, wenn die Empfangsschaltung (220) die wenigstens eine Signalspitze (PE3) des Eingangssignals (ES) detektiert.

8. Elektrische Schaltungsanordnung nach einem der Ansprüche 1 bis 7,
wobei das Eingangssignal (ES) und das Ausgangssignal (AS) Stromsignale sind.

9. Elektrische Schaltungsanordnung nach einem der Ansprüche 1 bis 8,
wobei die Sendeschaltung (120) und der Übertrager (210) dazu ausgebildet sind, das Eingangssignal (ES) mit einem Signalpuls (P1, P2, P3) für jede der einen steigenden und fallenden Flanke des digitalen Signals (PWM), das an die Sendeschaltung (120) angelegt ist, zu erzeugen.

10. Elektrische Schaltungsanordnung nach Anspruch 9,
- wobei die Empfangsschaltung (220) dazu ausgebildet ist, eine erste Zeitdauer (T₁) zwischen einem ersten und einem zweiten Signalpuls (P1, P2) zu detektieren, wobei der zweite Signalpuls (P2) an die Empfangsschaltung (220) in Bezug auf den ersten Signalpuls (P1) nachfolgend angelegt wird, und eine zweite Zeitdauer (T₁') zwischen dem zweiten Signalpuls (P2) und einem dritten Signalpuls (P3) zu detektieren, wobei der dritte Signalpuls (P3) an die Empfangsschaltung (220) in Bezug auf den zweiten Signalpuls (P2) nachfolgend angelegt wird,
- wobei die Empfangsschaltung (220) dazu ausgebildet ist, die erste und zweite Zeitdauer (T₁, T₁') zu vergleichen,
- wobei die Empfangsschaltung (220) das rekonstruierte digitale Signal (PWM') mit einem hohen Puls (HP) für die erste Zeitdauer (T₁) und mit einem niedrigen Puls (LP) für die zweite Zeitdauer (T₁') erzeugt, wenn die erste Zeitdauer (T1) kürzer als die zweite Zeitdauer (T₁') ist, und
- wobei die Empfangsschaltung (220) das rekonstruierte digitale Signal (PWM') für die zweite Zeitdauer (T₁') mit einem hohen Puls (HP) und für die erste Zeitdauer (T₁) mit einem niedrigen Puls (LP) erzeugt, wenn die zweite Zeitdauer (T₁') kürzer als die erste Zeitdauer (T₁) ist.

## Revendications

1. Un agencement du circuit électrique pour une communication isolée galvaniquement, comprenant:
- une première batterie (400a) comprenant une pluralité de premiers éléments de batterie (401a, ..., 407a) et une seconde batterie (400b) comprenant une pluralité de seconds éléments de batterie (401b, ..., 407b),
- un premier dispositif émetteur (100a) pour surveiller une condition de charge des premiers éléments de batterie (401a, ..., 407a) et un second dispositif émetteur (100b) pour surveiller une condition de charge des seconds éléments de batterie (401b, ..., 407b), le premier dispositif émetteur (100a) comprenant un circuit de détection (110) pour détecter une condition de charge de chacun des premiers éléments de batterie (401a, ..., 407a) et le deuxième dispositif émetteur (100b) comprenant un circuit de détection (110) pour détecter une condition de charge de chacun des deuxièmes éléments de batterie (401b, ..., 407b), les premier et deuxième dispositifs émetteurs (100a, 100b) comprenant respectivement un circuit émetteur (120) ayant un côté entrée (E120) pour appliquer un signal numérique (PWM) et un côté sortie (A120) pour générer un signal de sortie (AS) en fonction du signal numérique (PWM),
- un circuit récepteur (220) ayant un côté entrée (E220) pour recevoir un signal d'entrée (ES) et ayant un côté sortie (A220) pour générer un signal numérique reconstruit (PWM') en fonction du signal d'entrée (ES),
- un transformateur (210) pour le couplage inductif du côté sortie (A120) respectif du circuit émetteur (120) des premier et deuxième dispositifs émetteurs (100a, 100b) au côté entrée (E220) du circuit récepteur (220), sachant que le côté sortie (A120) du circuit émetteur (120) du deuxième dispositif émetteur (100b) est couplé au transformateur (210) au moyen du premier dispositif émetteur (100a),
- un circuit de charge (300) pour recharger les premiers éléments de batterie (401a, ..., 407a) et les seconds éléments de batterie (401b, ..., 407b), sachant que le circuit de charge (300) est couplé au circuit récepteur (220),
- sachant que les premier et deuxième dispositifs émetteurs (100a, 100b) fonctionnent dans un autre domaine de tension que le dispositif récepteur (200) et le circuit de charge (300),
- sachant que le circuit de détection respectif (110) des premier et second dispositifs émetteurs (100a, 100b) est configuré pour générer le signal numérique (PWM), lorsque le circuit de détection respectif (110) détecte que l'état de charge de l'un des premiers éléments de batterie (401a, ... , 407a) et des seconds éléments de batterie (401b, ... , 407b) est inférieur à une valeur de seuil,
- sachant que le circuit émetteur respectif (120) des premier et deuxième dispositifs émetteurs (100a, 100b) est configuré pour générer le signal de sortie (AS) en fonction du signal numérique (PWM).

2. L'agencement du circuit électrique de la revendication 1,
- sachant que le transformateur (210) et le circuit récepteur (220) sont intégrés dans une première puce (CH1),
- sachant que le circuit émetteur (120) est intégré dans une deuxième puce (CH2).

3. L'agencement du circuit électrique des revendications 1 ou 2,
sachant que le transformateur (210) et le circuit récepteur (220) sont logés dans un premier boîtier (PC1), et le circuit émetteur (120) est logé dans un second boîtier (PC2), ou sachant que le circuit émetteur (120), le circuit récepteur (220) et le transformateur (210) sont encapsulés dans le même boîtier.

4. L'agencement du circuit électrique des revendications 1 à 3,
- sachant que le circuit émetteur (120) est configuré pour générer le signal de sortie (AS) avec une première amplitude (PA1), lorsqu'un front montant du signal numérique (PWM) est appliqué au côté entrée (E120) du circuit émetteur,
- sachant que le circuit émetteur (120) est configuré pour générer le signal de sortie (AS) avec une seconde amplitude (PA2) différente de la première amplitude, lorsqu'un front descendant du signal numérique (PWM) est appliqué au côté entrée (E120) du circuit émetteur.

5. L'agencement du circuit électrique des revendications 1 à 4,
- sachant que le transformateur (210) est configuré pour générer le signal d'entrée (ES) avec une amplitude (PE1, PE2) en fonction de l'amplitude du signal de sortie (AS),
- sachant que le circuit récepteur (220) est configuré pour détecter une amplitude du signal d'entrée (ES) appliqué au côté entrée (E220) du circuit récepteur (220) et pour générer le signal numérique reconstruit (PWM') avec un front montant ou descendant en fonction de l'amplitude détectée du signal d'entrée (ES).

6. L'agencement du circuit électrique des revendications 1 à 5,
- sachant que le circuit émetteur (120) est configuré pour générer le signal de sortie (AS) avec une séquence d'au moins deux amplitudes différentes (PA1, PA2), lorsque l'un des fronts montant et descendant du signal numérique (PWM) est appliqué au côté entrée (E120) du circuit émetteur,
- sachant que le circuit émetteur (120) est configuré pour générer le signal de sortie (AS) avec au moins une amplitude (PA1), lorsque l'autre du front montant et descendant du signal numérique (PWM) est appliqué au côté entrée (E120) du circuit émetteur (120).

7. L'agencement du circuit électrique de la revendication 6,
- sachant que le transformateur (210) est configuré pour générer le signal d'entrée (ES) avec une séquence d'au moins deux pics de signal (PE1, PE2), lorsque la séquence des au moins deux amplitudes différentes (PA1, PA2) est appliquée au transformateur (210),
- sachant que le circuit récepteur (220) est configuré pour générer le signal numérique reconstruit (PWM') avec l'un des fronts montant et descendant, lorsque le circuit récepteur (220) détecte la séquence des au moins deux pics de signal (PE1, PE2) du signal d'entrée (ES),
- sachant que le transformateur (210) est configuré pour générer le signal d'entrée (ES) avec au moins un pic de signal (PE3), lorsque le signal de sortie (AS) est appliqué au transformateur avec la au moins une amplitude,
- sachant que le circuit récepteur (220) est configuré pour générer le signal numérique reconstruit (PWM') avec l'autre du front montant et descendant, lorsque le circuit récepteur (220) détecte la au moins un pic de signal (PE3) du signal d'entrée (ES).

8. L'agencement du circuit électrique des revendications 1 à 7,
sachant que le signal d'entrée (ES) et le signal de sortie (AS) sont des signaux courants.

9. L'agencement du circuit électrique des revendications 1 à 8,
sachant que le circuit émetteur (120) et le transformateur (210) sont configurés pour générer le signal d'entrée (ES) avec une impulsion de signal (P1, P2, P3) pour chacun des fronts montant et descendant du signal numérique (PWM) appliqué au circuit émetteur (120).

10. L'agencement du circuit électrique de la revendication 9,
- sachant que le circuit récepteur (220) est configuré pour détecter une première durée (T1) entre une première et une deuxième impulsion de signal (P1, P2), la deuxième impulsion de signal (P2) étant appliquée au circuit récepteur (220) ultérieurement en relation avec la première impulsion de signal (P1), et pour détecter une deuxième durée (T₁') entre la deuxième impulsion de signal (P2) et une troisième impulsion de signal (P3), la troisième impulsion de signal (P3) étant appliquée au circuit récepteur (220) ultérieurement en relation avec la deuxième impulsion de signal (P2),
- sachant que le circuit récepteur (220) est configuré pour comparer la première et la deuxième durée (T1, T1'),
- sachant que le circuit récepteur (220) génère le signal numérique reconstruit (PWM') avec une impulsion haute (HP) pour la première durée (T1) et avec une impulsion basse (LP) pour la deuxième durée (T1'), lorsque la première durée (T1) est plus courte que la deuxième durée (T1'), et
- sachant que le circuit récepteur (220) génère le signal numérique reconstruit (PWM') avec une impulsion haute (HP) pour la deuxième durée (T₁') et avec une impulsion basse (LP) pour la première durée (T1), lorsque la deuxième durée (T₁') est plus courte que la première durée (T1).
